# EUROPEAN PATENT APPLICATION

(11) **EP 4 708 446 A1**
(43) Date of publication of application: **11.03.2026**
(21) Application number: 25186204.1
(22) Date of filing: 30.06.2025
(51) Int. Cl.: H01M 10/42, G01N 23/04, G01N 23/083, G01N 23/18

(54) **BATTERY CELL DETECTION SYSTEM AND DETECTION METHOD THEREOF**

(30) Priority: 06.09.2024 CN 202411254730
(71) Applicant: NUCTECH COMPANY LIMITED, Beijing 100084 (CN); Tsinghua University, Haidian District, Beijing 100084 (CN)
(72) Inventor: HONG, Mingzhi, Beijing 100084 (CN); CHEN, Zhiqiang, Beijing 100084 (CN); ZHANG, Li, Beijing 100084 (CN); LI, Liang, Beijing 100084 (CN); CHANG, Ming, Beijing 100084 (CN); WANG, Zinan, Beijing 100084 (CN); JIANG, Tiansheng, Beijing 100084 (CN)
(74) Representative: Isarpatent

(57) **Abstract**

The present disclosure provides a battery cell detection system and a detection method thereof. The battery cell detection system includes: a conveying device (1) used to convey a battery cell to a gripping station; a first transfer device (2) disposed opposite to the conveying device (1) in a vertical direction, where the first transfer device (2) includes a first gripping mechanism (21) and a first moving mechanism (22) connected to each other, the first gripping mechanism (21) is used to grip the battery cell, and the first moving mechanism (22) is used to transfer the battery cell from the gripping station to a detection station and configured to move a portion to be detected of the battery cell to a predetermined position; and a detection device (3) disposed at the detection station, where the detection device (3) is used to detect the portion to be detected of the battery cell.

## Description

### TECHNICAL FIELD

The present disclosure relates to a field of detection device technology, and in particular to a battery cell detection system and a detection method thereof.

### BACKGROUND

Battery cell is an important component of a battery. Before being assembled into a battery, the battery cell needs to be inspected, especially to detect a degree of misalignment of electrode plates of the battery cell.

In the related art, the battery cell is placed on a rotary platform, with an optical machine and a detector arranged on both sides of the rotary platform. The rotary platform drives the battery cell to rotate for scanning. During a detection process, the battery cell remains in a rotating state, making it prone to damage. In addition, in a case of detecting a plurality of battery cells, the optical machine needs to stop beams multiple times to load and unload the plurality of battery cells, resulting in a low detection efficiency. Alternatively, the battery cell may be placed on a conveyor belt, with rotary optical machine and detector arranged on both sides of the conveyor belt. The battery cell is scanned in the process of moving with the conveyor belt. Since a position of the battery cell is relatively fixed, the battery cell needs to move with the conveyor belt multiple times to complete the detection of four ends, resulting in a low detection efficiency.

### SUMMARY

In view of this, embodiments of the present disclosure provide a battery cell detection system and a detection method thereof to solve the problem of a low detection efficiency in the existing battery cell detection systems.

In a first aspect of the present disclosure, a battery cell detection system is provided, including: a conveying device configured to convey a battery cell to a gripping station; a first transfer device disposed opposite to the conveying device in a vertical direction, where the first transfer device includes a first gripping mechanism and a first moving mechanism connected to each other, the first gripping mechanism is configured to grip the battery cell, and the first moving mechanism is configured to transfer the battery cell from the gripping station to a detection station and configured to move a portion to be detected of the battery cell to a predetermined position; and a detection device disposed at the detection station, where the detection device is configured to detect the portion to be detected of the battery cell.

According to embodiments of the present disclosure, the first moving mechanism includes: a first linear motion mechanism configured to be movable in a first direction to move the battery cell from the gripping station to the detection station; a first lifting mechanism configured to be movable in the vertical direction to move the battery cell to a detection reference plane of the detection device; and a first rotary mechanism connected to either the first linear motion mechanism or the first lifting mechanism and connected to the first gripping mechanism, where the first rotary mechanism is configured to drive the battery cell to rotate so that the portion to be detected of the battery cell rotates to the predetermined position.

According to embodiments of the present disclosure, the first moving mechanism further includes a second linear motion mechanism connected to the first linear motion mechanism and to the first lifting mechanism; and the second linear motion mechanism is configured to be movable in a second direction to drive the first lifting mechanism and the first rotary mechanism to move in the second direction, so that a rotation axis of the first rotary mechanism is located within a central plane of the detection device, where the second direction intersects with the first direction.

According to embodiments of the present disclosure, the first rotary mechanism is configured to drive the first gripping mechanism to rotate by a target angle, so that any portion to be detected of the battery cell rotates to the predetermined position.

According to embodiments of the present disclosure, the battery cell detection system further includes: a tray configured to carry the battery cell, where the conveying device is configured to covey the tray carrying the battery cell to the gripping station.

According to embodiments of the present disclosure, the battery cell detection system further includes a second transfer device, where: the first transfer device and the second transfer device are located on opposite sides of the detection device and have the same structure, and the second transfer device includes a second gripping mechanism and a second moving mechanism connected to each other; the first transfer device is configured to transfer a battery cell on one side of the detection device to the detection station, and the second transfer device is configured to transfer another battery cell on the other side of the detection device to the detection station; and the detection device is configured to simultaneously detect the battery cell gripped by the first transfer device and the battery cell gripped by the second transfer device.

According to embodiments of the present disclosure, the conveying device includes a first conveying mechanism and a second conveying mechanism, and a predetermined gap is formed between a tail end of the first conveying mechanism and a head end of the second conveying mechanism to allow radiation generated by the detection device to pass through; and the first conveying mechanism is configured to convey a battery cell to a first gripping station corresponding to the first conveying device, and the first conveying mechanism and the second conveying mechanism are configured to cooperatively convey another battery cell to a second gripping station corresponding to the second conveying device.

According to embodiments of the present disclosure, the conveying device further includes: a first stop mechanism disposed on the first conveying mechanism to stop a battery cell at the first gripping station; and/or a second stop mechanism disposed on the second conveying mechanism to stop another battery cell at the second gripping station.

In a second aspect of the present disclosure, a detection method for a battery cell detection system is provided, including: conveying a battery cell to a gripping station; transferring the battery cell from the gripping station to a detection station; and rotating a portion to be detected of the battery cell to a predetermined position to enable a detection of the portion to be detected of the battery cell.

According to embodiments of the present disclosure, the conveying a battery cell to a gripping station includes: conveying a battery cell to a first gripping station and conveying another battery cell to a second gripping station; and the transferring the battery cell from the gripping station to a detection station includes: transferring a battery cell from the first gripping station to the detection station and simultaneously transferring another battery cell from the second gripping station to the detection station.

According to embodiments of the present disclosure, the rotating a portion to be detected of the battery cell to a predetermined position to enable a detection of the portion to be detected of the battery cell includes: sequentially rotating a first portion to be detected and a second portion to be detected of a battery cell gripped by the first transfer device to the predetermined position, and sequentially detecting the first portion to be detected and the second portion to be detected; and simultaneously, sequentially rotating a third portion to be detected and a fourth portion to be detected of another battery cell gripped by the second transfer device to the predetermined position, and sequentially detecting the third portion to be detected and the fourth portion to be detected, where any portion to be detected of the battery cell gripped by the first transfer device and any portion to be detected of the battery cell gripped by the second transfer device are detected simultaneously.

According to embodiments of the present disclosure, the rotating a portion to be detected of the battery cell to a predetermined position to enable a detection of the portion to be detected of the battery cell includes: sequentially rotating a first portion to be detected, a second portion to be detected, a third portion to be detected and a fourth portion to be detected of a battery cell gripped by the first transfer device to the predetermined position, and sequentially detecting the first portion to be detected, the second portion to be detected, the third portion to be detected and the fourth portion to be detected; and simultaneously, sequentially rotating a fourth portion to be detected, a third portion to be detected, a second portion to be detected and a first portion to be detected of another battery cell gripped by the second transfer device to the predetermined position, and sequentially detecting the fourth portion to be detected, the third portion to be detected, the second portion to be detected and the first portion to be detected, where any portion to be detected of the battery cell gripped by the first transfer device and any portion to be detected of the battery cell gripped by the second transfer device are detected simultaneously.

According to embodiments of the present disclosure, the conveying a battery cell to a first gripping station and conveying another battery cell to a second gripping station includes: conveying a battery cell to the first gripping station corresponding to a first transfer device by a first conveying mechanism; and conveying another battery cell to the second gripping station corresponding to a second transfer device by the first conveying mechanism and a second conveying mechanism cooperatively, where a predetermined gap is formed between a tail end of the first conveying mechanism and a head end of the second conveying mechanism to allow radiation generated by a detection device to pass through.

### BRIEF DESCRIPTION OF THE DRAWINGS

Through the following descriptions of embodiments of the present disclosure with reference to the accompanying drawings, the above and other objectives, features and advantages of the present disclosure may be more apparent. In the accompanying drawings:
FIG. 1 schematically shows a schematic structural diagram of a battery cell detection system according to embodiments of the present disclosure;
FIG. 2 schematically shows a front view of a first transfer device according to embodiments of the present disclosure;
FIG. 3 schematically shows a side view of a first transfer device according to embodiments of the present disclosure;
FIG. 4 schematically shows a schematic diagram of a detection portion of a battery cell according to embodiments of the present disclosure; and
FIG. 5 schematically shows a flowchart of a detection method for a battery cell detection system according to embodiments of the present disclosure.

Reference numerals:
1: conveying device; 11: first conveying mechanism; 12: second conveying mechanism; 13: first stop mechanism; 14: second stop mechanism; 2: first transfer device; 21: first gripping mechanism; 22: first moving mechanism; 221: first linear motion mechanism; 2211: first slide rail; 2212: first slider; 2213: first mounting plate; 222: first lifting mechanism; 2221: lifting part; 223: first rotary mechanism; 2231: rotary part; 224: second linear motion mechanism; 2241: second slider: 2242: second slide rail; 2243: second mounting plate; 3: detection device; 31: radiation unit; 32: detector unit; 33: rotary frame; 4: second transfer device; 41: second gripping mechanism; 42: second moving mechanism; 221': first linear motion mechanism; 224': second linear motion mechanism; 421: second lifting mechanism; 422: second rotary mechanism; 100: battery cell; 101: first portion to be detected; 102: second portion to be detected; 103: third portion to be detected; 104: fourth portion to be detected; 200: tray.

### DETAILED DESCRIPTION OF EMBODIMENTS

In order to make objectives, technical solutions and advantages of the present disclosure clearer, the present disclosure will be described in detail below in combination with specific embodiments and with reference to the accompanying drawings. Obviously, the described embodiments are only some embodiments rather than all embodiments of the present disclosure. Based on the described embodiments of the present disclosure, all additional embodiments obtained by those ordinary skilled in the art without carrying out inventive effort fall within the scope of protection of the present disclosure.

Terms are used herein for the purpose of describing specific embodiments only and are not intended to limit the present disclosure. The terms "including", "containing", etc. used herein indicate the presence of the feature, step, operation and/or component, but do not exclude the presence or addition of one or more other features, steps, operations or components.

In the description of the present disclosure, it should be noted that unless otherwise explicitly specified and defined, the terms "installation", "connection" and "coupling" should be understood in a broad sense. For example, it may refer to a fixed connection, a detachable connection, or an integral connection; it may refer to a mechanical connection, or an electrical connection; it may refer to a direct connection, or an indirect connection through an intermediate medium; or it may refer to an internal communication of two elements. For those ordinary skilled in the art, specific meanings of the above-mentioned terms in the present disclosure may be understood according to specific situations.

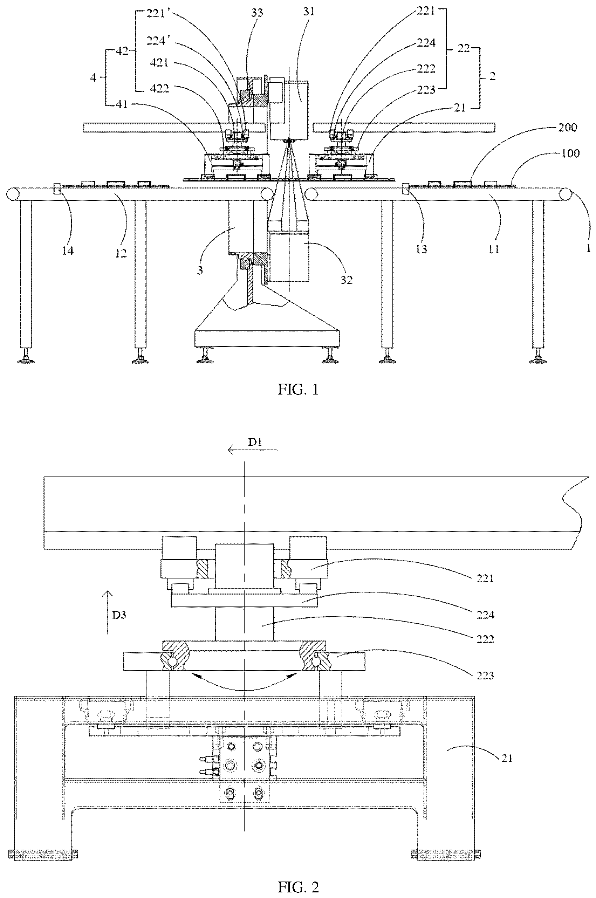

A battery cell detection system according to embodiments of the present disclosure will be described below with reference to FIG. 1 to FIG. 4.

As shown in FIG. 1, a battery cell detection system provided in embodiments of the present disclosure includes a conveying device 1, a first transfer device 2 and a detection device 3. The conveying device 1 is used to convey a battery cell 100 to a gripping station. The first transfer device 2 is disposed opposite to the conveying device 1 in a vertical direction. The first transfer device 2 includes a first gripping mechanism 21 and a first moving mechanism 22 connected to each other. The first gripping mechanism 21 is used to grip the battery cell 100. The first moving mechanism 22 is used to transfer the battery cell 100 from the gripping station to a detection station, and is configured to move a portion to be detected of the battery cell 100 to a predetermined position. The detection device 3 is disposed at the detection station and used to detect the portion to be detected of the battery cell 100.

Exemplarily, the battery cell detection system provided in embodiments of the present disclosure is used to detect four ends of a rectangular battery cell 100. An end of the battery cell 100 is a portion to be detected, and the battery cell 100 has four portions to be detected. According to detection requirements, it is possible to detect one or more portions to be detected of the battery cell 100. The battery cell detection system is mainly used to detect an alignment of electrode plates of the battery cell 100.

The battery cell detection system includes the conveying device 1, the first transfer device 2, and the detection device 3. The conveying device 1 and the first transfer device 2 are sequentially arranged in the vertical direction, and the detection device 3 is disposed at the detection station. The detection device 3 includes a radiation unit 31 and a detector unit 32, which are mounted on a rotary frame 33. A rotation of the rotary frame 33 drives the radiation unit 31 and the detector unit 32 to rotate around a central axis of the rotary frame 33. X-rays emitted by the radiation unit 31 pass through the portion to be detected of the battery cell 100, and the detector unit 32 receives the X-rays transmitted through the portion to be detected of the battery cell 100 and converts them into an electrical signal. The electrical signal is processed to generate a scan image. Based on the scan image, it is determined whether the portion to be detected of the battery cell 100 has defects, thus completing a detection of the portion to be detected.

The conveying device 1 may be a belt-type conveying apparatus and includes a driving roller, a driven roller, and a conveyor belt. The conveyor belt is looped around the driving roller and the driven roller. The gripping station is located in a conveying direction of the conveyor belt. The battery cell 100 is placed on the conveyor belt and moves with the conveyor belt to the gripping station.

The battery cell 100 from a previous process may be loaded onto the conveyor belt of the conveying device 1 either by a loading device or manually by operators.

The first transfer device 2 includes a first gripping mechanism 21 and a first moving mechanism 22 connected to each other. The first gripping mechanism 21 is disposed opposite to a conveying surface of the conveyor belt and is used to grip the battery cell 100. The first moving mechanism 22 may perform a linear motion and a rotational motion and is used to drive the first gripping mechanism 21 to reciprocate between the gripping station and the detection station.

The first moving mechanism 22 may drive the first gripping mechanism 21 to move to the gripping station, and the first gripping mechanism 21 may grip the battery cell 100 on the conveyor belt. After the battery cell 100 is gripped by the first gripping mechanism 21, the battery cell 100 is separated from the conveying surface of the conveyor belt, and the first moving mechanism 22 moves the battery cell 100 to the detection station. At the detection station, the first moving mechanism 22 may lift the battery cell 100 in the vertical direction to a predetermined height. At the predetermined height, the battery cell 100 is located within a detection reference plane of the detection device 3. A distance between the detection reference plane and an emitting end of the radiation unit 31 meets a first distance requirement, and a distance between the detection reference plane and a receiving end of the detector unit 32 meets a second distance requirement.

When the battery cell 100 reaches the predetermined height, the first moving mechanism 22 may rotate the battery cell 100 by a predetermined angle, so that the portion to be detected of the battery cell 100 is in a beam region of the detection reference plane. At this point, the portion to be detected of the battery cell 100 is located at the predetermined position. A predetermined position information includes a height information and an angle information of the battery cell 100. When the portion to be detected of the battery cell 100 is located at the predetermined position, the radiation unit 31 and the detector unit 32 rotate around the central axis to detect the portion to be detected.

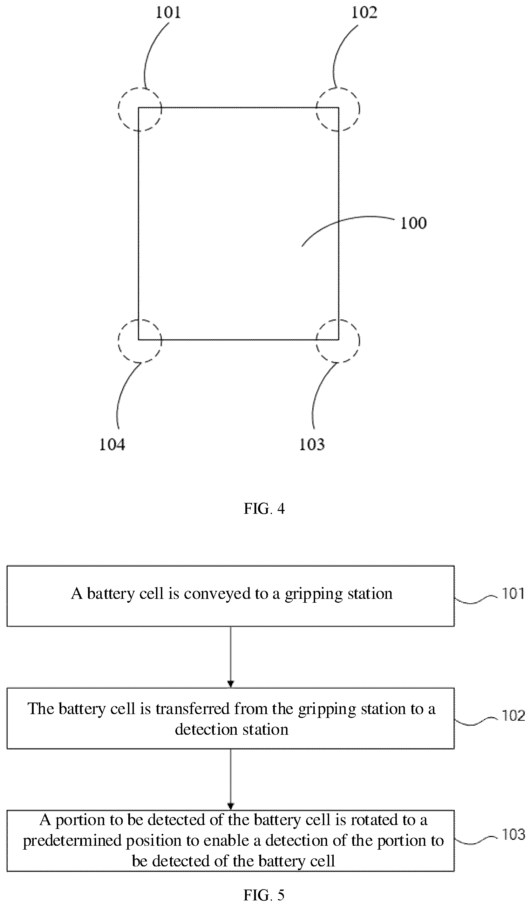

As shown in FIG. 4, the battery cell 100 has four portions to be detected, which are defined as a first portion to be detected 101, a second portion to be detected 102, a third portion to be detected 103, and a fourth portion to be detected 104, respectively. The first portion to be detected 101 and the third portion to be detected 103 are located on a first diagonal of the battery cell 100, and the second portion to be detected 102 and the fourth portion to be detected 104 are located on a second diagonal of the battery cell 100. Two detection processes will be described below according to detection requirements.

If it is required to detect the first portion to be detected 101 and the second portion to be detected 102 of the battery cell 100, the first moving mechanism 22 may rotate to bring the first portion to be detected 101 of the battery cell 100 into the beam region, and the first portion to be detected 101 is scanned to generate a first scan image. According to the first scan image, it is determined whether the first portion to be detected 101 has a defect. After a detection of the first portion to be detected 101 is completed, the first moving mechanism 22 may rotate to bring the second portion to be detected 102 of the battery cell 100 into the beam region, and the second portion to be detected 102 is scanned to generate a second scan image. According to the second scan image, it is determined whether the second portion to be detected 102 has a defect. Thus, the detection of the first portion to be detected 101 and the second portion to be detected 102 is completed.

If it is required to detect all the four portions to be detected of the battery cell 100, the first moving mechanism 22 may sequentially rotate the first portion to be detected 101, the second portion to be detected 102, the third portion to be detected 103, and the fourth portion to be detected 104 of the battery cell 100 into the beam region. According to a first scan image, a second scan image, a third scan image, and a fourth scan image generated by the scans, it is determined whether the four portions to be detected of the battery cell 100 have defects.

During the detection process, the battery cell 100 remains in a horizontal orientation, while the radiation unit 31 and the detector unit 32 rotate about the central axis. The battery cell 100 does not need to rotate, which effectively avoids a motion-related damage to the battery cell 100 caused by rotation during the detection process.

In the prior art, the battery cell moves with the conveyor belt to the detection station, where the battery cell is placed on the conveyor belt. After one portion to be detected of the battery cell has been detected, the battery cell moves with the conveyor belt to a tail end of the conveyor belt. After that, the battery cell is placed at a head end of the conveyor belt, a position of the battery cell is adjusted, and the battery cell moves again with the conveyor belt to the detection station to detect a next portion to be detected. In a case of detecting a plurality of portions to be detected of the battery cell, the battery cell needs to move multiple times with the conveyor belt, and the position of the battery cell needs to be adjusted multiple times, resulting in a low detection efficiency.

In the battery cell detection system of the present disclosure, the battery cell 100 is separated from the conveyor belt at the detection station. After one portion to be detected of the battery cell 100 has been detected, the battery cell 100 does not need to move again from the head end of the conveyor belt to the detection station. Instead, at the detection station, the battery cell 100 may be rotated to bring the next portion to be detected to the predetermined position for detection, which effectively improves the detection efficiency. In addition, it is possible to rotate the portion to be detected of the battery cell 100 to the predetermined position according to detection requirements, which is conductive to a detection flexibility.

It may be understood that while the battery cell 100 gripped by the first gripping mechanism 21 is being detected, the conveying device 1 may further convey a next battery cell 100 to be detected to the gripping station, and the conveying device 1 further functions to buffer the next battery cell 100 to be detected.

After the detection of the battery cell 100 is completed, the first moving mechanism 22 may descend in the vertical direction until the first gripping mechanism 21 is lowered close to the conveying surface of the conveyor belt. The first gripping mechanism 21 may release the battery cell 100, which is placed on the conveyor belt and then moves with the conveyor belt to an unloading station.

After the first gripping mechanism 21 releases the battery cell 100, the first transfer device 2 moves from the detection station to the gripping station to perform detection of the next battery cell 100.

In a case of detecting a plurality of battery cells 100, the radiation unit 31 and the detector unit 32 remain in a rotating state. The radiation unit 31 does not need to be repeatedly powered on and off, which helps improve an operation stability of the detection device 3.

The conveying device 1 is used to convey the battery cell 100 to be detected to the gripping station and convey the battery cell 100 that has been detected to the unloading station, and it further functions to buffer the battery cell 100 to be detected. The first gripping mechanism 21 is used to grip the battery cell 100. The first moving mechanism 22 is used to move the battery cell 100 from the gripping station to the detection station by a linear motion and a rotational motion, and rotate the portion to be detected of the battery cell 100 into the beam region of the detection device 3, enabling detection of any portion to be detected by the detection device 3.

After the battery cell 100 is gripped by the first gripping mechanism 21 and separated from the conveying surface of the conveying device 1, the first moving mechanism 22 may adjust a position and orientation of the battery cell 100 to enable the detection of any portion to be detected of the battery cell 100, which facilitates the detection flexibility and improves the detection efficiency.

In embodiments of the present disclosure, the conveying device 1 is used to convey and buffer the battery cell 100 to be detected. The first transfer device 2 is used to transfer the battery cell 100 from the gripping station to the detection station. At the detection station, according to detection requirements, the first moving mechanism 22 may move any portion to be detected of the battery cell 100 to the predetermined position to detect one or more portions to be detected of the battery cell 100, which facilitates the detection flexibility and improves the detection efficiency.

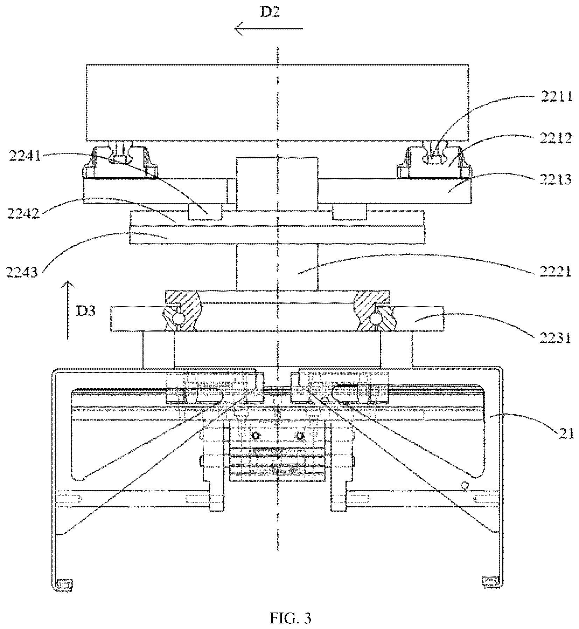

As shown in FIG. 2 and FIG. 3, in an optional embodiment, the first moving mechanism includes a first linear motion mechanism 221, a first lifting mechanism 222, and a first rotary mechanism 223. The first linear motion mechanism 221 is configured to move in a first direction to move the battery cell 100 from the gripping station to the detection station. The first lifting mechanism 222 is configured to move in the vertical direction to move the battery cell 100 to the detection reference plane of the detection device 3. The first rotary mechanism 223 is connected to either the first linear motion mechanism 221 or the first lifting mechanism 222 and to the first gripping mechanism 21, and it is used to rotate the battery cell 100 to bring the portion to be detected of the battery cell 100 to the predetermined position.

Specifically, the first linear motion mechanism 221 moves in the first direction, which is parallel to the conveying direction of the conveying device 1. The first lifting mechanism 222 moves in the vertical direction, and a rotation axis of the first rotary mechanism 223 is parallel to the vertical direction. The first direction is shown as direction D1 in FIG. 2, and the vertical direction is shown as direction D3 in FIG. 2 and FIG. 3. An arc arrow shown in FIG. 2 indicates a rotation direction.

The first transfer device 2 further includes a mounting frame, which includes a vertical beam and a horizontal support beam. One end of the vertical beam is fixed to a workbench or a ground, and the other end of the vertical beam is connected to the horizontal support beam. The first linear motion mechanism 221 is mounted on the horizontal support beam.

The first linear motion mechanism 221 may be selected from a rack and pinion transmission mechanism, a screw and nut transmission mechanism, a synchronous belt transmission mechanism, a slide rail and slider motion mechanism, or the like. Optionally, the first linear motion mechanism 221 includes a first slide rail 2211, a first slider 2212, and a first mounting plate 2213. The first slider 2212 is slidably connected to the first slide rail 2211.

The first slide rail 2211 is mounted on a bottom surface of the horizontal support beam. Optionally, two first slide rails 2211 are provided, and the two first slide rails 2211 are spaced apart in a width direction of the horizontal support beam. The first slider 2212 is mounted on a top surface of the first mounting plate 2213. One, two, or more first sliders 2212 are mounted on each first slide rail 2211. The first linear motion mechanism 221 further includes a first horizontal drive component used to drive the first slider 2212 to move along the first slide rail 2211.

The first lifting mechanism 222 includes a lifting drive component and a lifting part 2221. A fixed end of the lifting drive component is connected to the first mounting plate 2213, and a drive end of the lifting drive component is connected to one end of the lifting part 2221. The other end of the lifting part 2221 is connected to the first rotary mechanism 223. The lifting drive component is used to drive the lifting part 2221 to move up and down in the vertical direction.

The first rotary mechanism 223 includes a rotation drive component, a rotary part 2231 and a connection part. The rotary part 2231 is rotatably connected to the lifting part 2221. The connection part is provided on a bottom surface of the rotary part 2231, and the rotary part 2231 is connected to the first gripping mechanism 21 through the connection part. The rotation drive component is used to drive the rotary part 2231 to rotate.

The first gripping mechanism 21 includes two clamping parts, which may move close to away from each other to grip he battery cell 100.

An operation process of components of the first transfer device 2 will be described in detail below.

When the battery cell 100 to be detected is conveyed to the gripping station, the first transfer device 2 moves to the gripping station, and the lifting drive component drives the lifting part 2221 to move downward in the vertical direction until the first gripping mechanism 21 is close to the battery cell 100 at the gripping station. After the two clamping parts of the first gripping mechanism 21 grip the battery cell 100, the first horizontal drive component drives the first slider 2212 to move along the first slide rail 2211, thereby moving the battery cell 100 to the detection station. The lifting drive component drives the lifting part 2221 to move upward in the vertical direction until the battery cell 100 is moved to the detection reference plane in the vertical direction. After that, the rotation drive component drives the rotary part 2231 to rotate to bring the portion to be detected of the battery cell 100 into the beam region, enabling detection of the portion to be detected by the detection device 3.

If it is required to detect all the four portions to be detected of the battery cell 100, the rotary part 2231 sequentially rotates the first portion to be detected 101, the second portion to be detected 102, the third portion to be detected 103, and the fourth portion to be detected 104 of the battery cell 100 into the beam region to complete the detection of the four portions to be detected.

After the battery cell 100 has been detected, the first horizontal drive component drives the first slider 2212 to move along the first slide rail 2211, causing the first transfer device 2 to move from the detection station to the gripping station in the first direction to detect a next battery cell 100.

The first horizontal drive component drives the first slider 2212 to move along the first slide rail 2211, thereby moving the battery cell 100 from the gripping station to the detection station. The lifting drive component drives the lifting part 2221 to move in the vertical direction, thereby enabling the first gripping mechanism 21 to grip the battery cell 100 and move the battery cell 100 to the detection reference plane. The rotation drive component drives the rotary part 2231 to rotate, thereby rotating any portion to be detected of the battery cell 100 into the beam region. The first linear motion mechanism 221, the first lifting mechanism 222, the first rotary mechanism 223, and the first gripping mechanism 21 cooperate with each other to achieve an orderly integration of a gripping operation, a lifting operation, a horizontal moving operation, and a rotating operation, which facilitates an intelligent operation of the battery cell detection system.

As shown in FIG. 2, in an optional embodiment, the first moving mechanism 22 further includes a second linear motion mechanism 224, which is connected to the first linear motion mechanism 221 and to the first lifting mechanism 222. The second linear motion mechanism 224 is configured to move in a second direction and used to drive the first lifting mechanism 222 and the first rotary mechanism 223 to move in the second direction, so that a rotation axis of the first rotary mechanism 223 is located within a central plane of the detection device 3. The second direction intersects with the first direction.

Specifically, the second linear motion mechanism 224 may move in the second direction, which is parallel to a horizontal direction and perpendicular to the first direction. The second direction is shown as direction D2 in FIG. 3.

The second linear motion mechanism 224 includes a second slide rail 2242, a second slider 2241 and a second mounting plate 2243. The second slider 2214 is mounted on a bottom surface of the first mounting plate 2213. Two groups of second sliders are spaced apart on the bottom surface of the first mounting plate 2213, and each group of second sliders includes two second sliders 2241 spaced part from each other. Two second slide rails 2242 are mounted on a top surface of the second mounting plate 2243, and the two second slide rails 2242 correspond to the two groups of second sliders, respectively. The second slider 2241 is slidably connected to the second slide rail 2242. The first lifting mechanism 222 may be mounted on the second mounting plate 2243.

The second slide rail 2242 may slide relative to the second slider 2241, driving the first lifting mechanism 222 and the first rotary mechanism 223 to move in the second direction, thereby positioning the rotation axis of the first rotary mechanism 223 within the central plane of the detection device 3. In this way, it is possible to perform a further fine adjustment of the position of the battery cell 100 to ensure that a central plane of the battery cell 100 coincides with the central plane of the detection device 3, thereby avoiding a leftward or rightward deviation of the battery cell 100 in the second direction, and ensuring that the portion to be detected may be completely located in the beam region.

A sliding engagement position between the second slide rail 2242 and the second slider 2241 may be adjusted manually or by a second horizontal drive component.

The second linear motion mechanism 224 may drive the first lifting mechanism 222, the first rotary mechanism 223, and the first gripping mechanism 21 to move in the second direction to ensure that the central plane of the battery cell 100 coincides with the central plane of the detection device 3. As a result, after the first rotary mechanism 223 rotates by a target angle, the portion to be detected of the battery cell 100 may be precisely located in the beam region, thereby ensuring a detection accuracy.

In an optional embodiment, the first rotary mechanism 223 is configured to drive the first gripping mechanism 21 to rotate by a target angle, so that any portion to be detected of the battery cell 100 is rotated to the predetermined position.

Specifically, the first rotary mechanism 223 may rotate 360 degrees about the rotation axis, so as to rotate any portion to be detected of the battery cell 100 to the predetermined position.

In a length direction of the battery cell 100, the battery cell 100 has a first end and a second end opposite to each other. The first portion to be detected 101 and the second portion to be detected 102 are located at the first end, while the third portion to be detected 103 and the fourth portion to be detected 104 are located at the second end.

The first rotary mechanism 223 may rotate by a first angle to bring the first portion to be detected 101 to the predetermined position to complete the detection, then rotate by a second angle to bring the second portion to be detected 102 to the predetermined position to complete the detection, subsequently rotate by a third angle to bring the third portion to be detected 103 to the predetermined position to complete the detection, and further rotate by a fourth angle to bring the fourth portion to be detected 104 to the predetermined position to complete the detection.

At the detection station, the four portions to be detected of the battery cell 100 may be detected sequentially through the rotation of the first rotary mechanism 223, which helps to improve the detection efficiency and the detection quality.

As shown in FIG. 1, in an optional embodiment, the battery cell detection system further includes a tray 200, which is used to carry the battery cell 100. The conveying device is used to convey the tray carrying the battery cell 100 to the gripping station.

Specifically, the battery cell detection system further includes the tray 200 used to carry the battery cell 100. A structure of the tray 200 is not specifically limited. The tray 200 carrying the battery cell 100 moves with the conveyor belt. The tray 200 may reduce a friction between the conveyor belt and the battery cell 100, so as to protect the battery cell 100.

The two clamping parts of the first gripping mechanism 21 clamp the tray 200 to transfer the battery cell 100 from the gripping station to the detection station. The first gripping mechanism 21 is in direct contact with the tray 200 to avoid clamping the battery cell 100 directly that may cause a squeezing damage to the battery cell 100 and thus protect the battery cell 100.

The tray 200 carries the battery cell 100 to avoid direct contact between the battery cell 100 and the conveyor belt or the first gripping mechanism 21, thereby protecting the battery cell 100 effectively.

Optionally, the tray 200 may carry a plurality of battery cells 100, which are stacked in the vertical direction. At the detection station, it is possible to detect the portions to be detected of the plurality of battery cells 100 during a single scanning process, which helps to further improve the detection efficiency.

As shown in FIG. 1, in an optional embodiment, the battery cell detection system further includes a second transfer device 4. The first transfer device 2 and the second transfer device 4 are located on opposite sides of the detection device 3. The second transfer device has the same structure as the first transfer device. The second transfer device 4 includes a second gripping mechanism 41 and a second moving mechanism 42 connected to each other. The first transfer device 2 is used to transfer a battery cell 100 on one side of the detection device 3 to the detection station, and the second transfer device 4 is used to transfer another battery cell 100 on the other side of the detection device 3 to the detection station. The detection device 3 is used to simultaneously detect the battery cell 100 gripped by the first transfer device 2 and the battery cell 100 gripped by the second transfer device 4.

Specifically, the second transfer device 4 has the same structure as the first transfer device 2. The first transfer device 2 and the second transfer device 4 are arranged symmetrically with respect to the detection device 3. That is, the first transfer device 2 and the second transfer device 4 are respectively disposed on a first side and a second side of the detection device 3 in the conveying direction of the conveying device 1.

The first transfer device 2 includes a first gripping mechanism 21 and a first moving mechanism 22, and the first moving mechanism 22 includes a first linear motion mechanism 221, a first lifting mechanism 222, a first rotary mechanism 223, and a second linear motion mechanism 224. The second transfer device 4 includes a second gripping mechanism 41 and ae second moving mechanism 42, and the second moving mechanism 42 includes a first linear motion mechanism 221', a second linear motion mechanism 224', a second lifting mechanism 421, and a second rotary mechanism 422. The first linear motion mechanism 221' has the same structure as the first linear motion mechanism 221, the second linear motion mechanism 224' has the same structure as the second linear motion mechanism 224, the second lifting mechanism 421 has the same structure as the first lifting mechanism 222, and the second rotary mechanism 422 has the same structure as the first rotary mechanism 223.

While the first transfer device 2 grips a battery cell 100 and transfers it to the detection station, the second transfer device 4 may simultaneously grip a battery cell 100 and transfers it to the detection station. The detection device 3 may simultaneously detect the battery cell 100 gripped by the first transfer device 2 and the battery cell 100 gripped by the second transfer device 4.

A first gripping station and a second gripping station are provided in the conveying direction of the conveying device 1. The conveying device 1 conveys two adjacent battery cells 100 to the first gripping station and the second gripping station, respectively. For ease of description, the two battery cells 100 are defined as a first battery cell and a second battery cell. The battery cell detection system has a plurality of detection modes according to a cooperative relationship between the two transfer devices, the conveying device 1, and the detection device 3.

A detection process of a first detection mode will be described in detail below.

The conveying device 1 conveys the first battery cell to the first gripping station. The first transfer device 2 moves to the first gripping station, and the first gripping mechanism 21 grips the first battery cell. The first linear motion mechanism 221 moves the first battery cell to the detection station by a horizontal linear motion. The first lifting mechanism 222 moves the first battery cell to the detection reference plane by a lifting motion. The first rotary mechanism 223 rotates the first portion to be detected 101 of the first battery cell into the beam region by a rotational motion, and the detection device 3 detects the first portion to be detected 101. After that, the first rotary mechanism 223 rotates the second portion to be detected 102 of the first battery cell into the beam region by a rotational motion, and the detection device 3 detects the second portion to be detected.

After the detection of the first portion to be detected 101 and the second portion to be detected 102 is completed, the first lifting mechanism 222 lowers the first battery cell to a position near the conveying surface of the conveyor belt. The first gripping mechanism 21 places the first battery cell on the conveyor belt, and the first battery cell moves with the conveyor belt to the second gripping station.

The second transfer device 4 moves to the second gripping station, and the second gripping mechanism 41 grips the first battery cell. The first linear motion mechanism 221' of the second moving mechanism 42 moves the first battery cell to the detection station by a horizontal linear motion. The second lifting mechanism 421 moves the first battery cell to the detection reference plane by a lifting motion. The second rotary mechanism 422 rotates the third portion to be detected 103 of the first battery cell into the beam region by a rotational motion, and the detection device 3 detects the third portion to be detected 103. After that, the second rotary mechanism 422 rotates the fourth portion to be detected 104 of the first battery cell into the beam region by a rotational motion, and the detection device 3 detects the fourth portion to be detected 104.

It may be understood that when the first battery cell moves to the second gripping station, the second battery cell moves with the conveyor belt to the first gripping station. While the second gripping mechanism 41 grips the first battery cell at the second gripping station, the first gripping mechanism 21 simultaneously grips the second battery cell at the first gripping station.

When the second moving mechanism 42 moves the first battery cell from the second gripping station to the detection station, the first moving mechanism 22 moves the second battery cell from the first gripping station to the detection station. While the second rotary mechanism 422 rotates the third portion to be detected 103 of the first battery cell into the beam region by a rotational motion, the first rotary mechanism 223 simultaneously rotates the first portion to be detected 101 of the second battery cell into the beam region by a rotational motion. The detection device 3 may then simultaneously detect the third portion to be detected 103 of the first battery cell and the first portion to be detected 101 of the second battery cell. Similarly, the detection device 3 may simultaneously detect the fourth portion to be detected 104 of the first battery cell and the second portion to be detected 102 of the second battery cell.

The first transfer device 2 sequentially moves the first portion to be detected 101 and the second portion to be detected 102 of the battery cell 100 into the beam region to complete the detection of the first portion to be detected 101 and the second portion to be detected 102. The second transfer device 4 sequentially moves the third portion to be detected 103 and the fourth portion to be detected 104 of the battery cell 100 into the beam region to complete the detection of the third portion to be detected 103 and the fourth portion to be detected 104.

While the first transfer device 2 moves a portion to be detected of a battery cell 100 into the beam region, the second transfer device 4 simultaneously moves a portion to be detected of another battery cell 100 into the beam region. The detection device 3 may then detect the two portions to be detected of the two battery cells 100 simultaneously, which helps to improve the detection efficiency.

A detection process of a second detection mode will be described in detail below.

The conveying device 1 conveys the first battery cell to the first gripping station, and conveys the second battery cell to the second gripping station.

The first transfer device 2 moves to the first gripping station, and the second transfer device 4 simultaneously moves to the second gripping station. The first gripping mechanism 21 grips the first battery cell at the first gripping station, and the first moving mechanism 22 moves the first battery cell to the detection station. At the same time, the second gripping mechanism 41 grips the second battery cell at the second gripping station, and the second moving mechanism 42 moves the second battery cell to the detection station.

The first rotary mechanism 223 rotates the first portion to be detected 101 of the first battery cell into the beam region, and the second rotary mechanism 422 simultaneously rotates the fourth portion to be detected 104 of the second battery cell into the beam region. The detection device 3 may then simultaneously detect the first portion to be detected 101 of the first battery cell and the fourth portion to be detected 104 of the second battery cell.

Subsequently, the first rotary mechanism 223 rotates the second portion to be detected 102 of the first battery cell into the beam region, and the second rotary mechanism 422 simultaneously rotates the third portion to be detected 103 of the second battery cell into the beam region. The detection device 3 may then simultaneously detect the second portion to be detected 102 of the first battery cell and the third portion to be detected 103 of the second battery cell.

Then, the first rotary mechanism 223 rotates the third portion to be detected 103 of the first battery cell into the beam region, and the second rotary mechanism 422 simultaneously rotates the second portion to be detected 102 of the second battery cell into the beam region. The detection device 3 may then simultaneously detect the third portion to be detected 103 of the first battery cell and the second portion to be detected 102 of the second battery cell.

After that, the first rotary mechanism 223 rotates the fourth portion to be detected 104 of the first battery cell into the beam region, and the second rotary mechanism 422 simultaneously rotates the first portion to be detected 101 of the second battery cell into the beam region. The detection device 3 may then simultaneously detect the fourth portion to be detected 104 of the first battery cell and the first portion to be detected 101 of the second battery cell.

The first transfer device 2 sequentially moves the first portion to be detected 101, the second portion to be detected 102, the third portion to be detected 103, and the fourth portion to be detected 104 of the first battery cell into the beam region to complete the detection of the four portions to be detected. At the same time, the second transfer device 4 sequentially moves the fourth portion to be detected 104, the third portion to be detected 103, the second portion to be detected 102, and the first portion to be detected 101 of the second battery cell into the beam region to complete the detection of the four portions to be detected.

While the first transfer device 2 moves a portion to be detected of a battery cell 100 into the beam region, the second transfer device 4 simultaneously moves a portion to be detected of another battery cell 100 into the beam region. The detection device 3 may then simultaneously detect the two portions to be detected of the two battery cells 100, which helps to improve the detection efficiency.

As shown in FIG. 1, in an optional embodiment, the conveying device 1 includes a first conveying mechanism 11 and a second conveying mechanism 12. A predetermined gap is formed between a tail end of the first conveying mechanism 11 and a head end of the second conveying mechanism 12. The predetermined gap is configured to allow radiation generated by the detection device 3 to pass through. The first conveying mechanism 11 is used to convey a battery cell 100 to a first gripping station corresponding to the first conveying device 2. The first conveying mechanism 11 and the second conveying mechanism 12 may operate in cooperation to convey another battery cell 100 to a second gripping station corresponding to the second conveying device 4.

Specifically, the conveying device 1 includes a first conveying mechanism 11 and a second conveying mechanism 12. The first conveying mechanism 11 has the same structure as the second conveying mechanism 12. The first conveying mechanism 11 and the first transfer device 2 are arranged sequentially in the vertical direction, and the second conveying mechanism 12 and the second transfer device 4 are arranged sequentially in the vertical direction.

The first conveying mechanism 11 includes a first driving roller, a first driven roller, and a first conveyor belt, with the first conveyor belt looped around the first driving roller and the first driven roller. The second conveying mechanism 12 includes a second driving roller, a second driven roller, and a second conveyor belt, with the second conveyor belt looped around the second driving roller and the second driven roller. A first conveying surface of the first conveyor belt and a second conveying surface of the second conveyor belt are located on the same horizontal plane.

The first conveying mechanism 11 and the second conveying mechanism 12 are located on opposite sides of the detection device 3. The tail end of the first conveying mechanism 11 is opposite to the head end of the second conveying mechanism 12, and a predetermined gap is formed between the tail end of the first conveying mechanism 11 and the head end of the second conveying mechanism 12. A conical contour surface of a radiation beam emitted by the radiation unit 31 is located in the predetermined gap. The radiation is directly received by the detector unit 32 after passing through the portion to be detected of the battery cell 100, thereby effectively avoiding an interference of the conveying device 1 to the imaging system, which helps improve the quality of the scan image and further improve the detection accuracy.

The first conveying mechanism 11 and the second conveying mechanism 12 cooperate to convey the battery cell 100. After the detection of the battery cell 100 gripped by the first transfer device 2 is completed, the first gripping mechanism 21 places the battery cell 100 on the first conveyor belt. With the rotation of the first conveyor belt and the second conveyor belt, the battery cell 100 moves from the first conveyor belt to the second conveyor belt, and further moves with the second conveyor belt to the second gripping station.

In embodiments of the present disclosure, the predetermined gap is formed between the tail end of the first conveying mechanism 11 and the head end of the second conveying mechanism 12. The radiation is directly received by the detector unit 32 after passing through the battery cell 100, thereby effectively avoiding the interference of the conveying device 1 to the imaging system, which helps improve the quality of the scan image and further improve the detection accuracy.

As shown in FIG. 1, in an optional embodiment, the conveying device 1 further includes a first stop mechanism 13 and/or a second stop mechanism 14. The first stop mechanism 13 is disposed on the first conveying mechanism 11 and is used to stop a battery cell 100 at the first gripping station. The second stop mechanism 14 is disposed on the second conveying mechanism 12 and is used to stop another battery cell 100 at the second gripping station.

Specifically, the conveying device 1 further includes a first stop mechanism 13 and/or a second stop mechanism 14. The first stop mechanism 13 is provided at a first position of the first conveying mechanism 11, where the first position corresponds to the first gripping station. The second stop mechanism 14 is provided at a second position of the second conveying mechanism 12, where the second position corresponds to the second gripping station.

The first battery cell and the second battery cell move with the conveyor belt to the first position and the second position, respectively. The first stop mechanism 13 stops the first battery cell at the first position, and the second stop mechanism 14 stops the second battery cell at the second position. The first stop mechanism 13 has a positioning effect on the first battery cell, and the second stop mechanism 14 has a positioning effect on the second battery cell.

Subsequently, the first transfer device 2 moves from the detection station to the first gripping station to grip the first battery cell and transfer the first battery cell to the detection station. At the same time, the second transfer device 4 moves from the detection station to the second gripping station to grip the second battery cell and transfer the second battery cell to the detection station.

The first stop mechanism 13 has the same structure as the second stop mechanism 14. The structure of the first stop mechanism 13 will be described below.

The first stop mechanism 13 includes an extendable drive member and a stop member. The extendable drive member is capable of extending and retracting, and may be selected from a pneumatic cylinder, a hydraulic cylinder, an electric push rod, or the like. The extendable drive member may be mounted on the support frame of the first conveying mechanism 11, with an extendable end of the extendable drive member connected to the stop member. The stop member may be in a plate shape and is placed horizontally. An extension direction of the stop member is perpendicular to the conveying direction.

The battery cell 100 moves with the first conveyor belt to the first gripping station. The extendable end of the extendable drive member extends to move the stop member to above the first conveyor belt. The tray 200 comes into contact with a stop surface of the stop member and stops moving, so that the battery cell 100 is positioned at the first gripping station.

When the battery cell 100 needs to move from the first conveyor belt to the second conveyor belt, the extendable end of the extendable drive member retracts to move the stop member outside the first conveyor belt, allowing the battery cell 100 to move from the first conveyor belt to the second conveyor belt.

While the detection device 3 is detecting the first battery cell and the second battery cell, a next group of battery cells moves with the first conveying mechanism 11 to the first position. The first stop mechanism 13 stops the next group of battery cells at the first position, serving as a stopper and a buffer for the next group of battery cells. This shortens a time required for the first battery cell and the second battery cell in the next group of battery cells to move to the first position and the second position, respectively, which helps to improve the detection efficiency for batch products.

Further, while the detection device 3 detects the two battery cells 100 gripped by the first gripping mechanism 21 and the second gripping mechanism 41, the battery cell 100 that does not need to be detected may be directly moved below the detection reference plane from the first conveyor belt to the second conveyor belt. Thus, the battery cell detection system has both a full inspection function and a sampling inspection function.

As shown in FIG. 5, the present disclosure further provides a detection method for a battery cell detection system, including step 101 to step 103.

In step 101, a battery cell 100 is conveyed to a gripping station.

In step 102, the battery cell 100 is transferred from the gripping station to a detection station.

In step 103, a portion to be detected of the battery cell 100 is rotated to a predetermined position to enable a detection of the portion to be detected of the battery cell 100.

Specifically, the battery cell detection system includes a conveying device 1, a first transfer device 2, and a detection device 3. The structures of the conveying device 1, the first transfer device 2 and the detection device 3 are as described above.

The battery cell 100 to be detected moves with the conveyor belt to the gripping station, where the battery cell 100 is gripped by the first gripping mechanism 21. The first moving mechanism 22 performs a linear motion in the first direction to move the battery cell 100 from the gripping station to the detection station. The first moving mechanism 22 then moves the battery cell 100 in the vertical direction to the detection reference plane of the detection device 3. Subsequently, the first moving mechanism 22 performs a rotational motion to rotate the portion to be detected of the battery cell 100 into the beam region, where the portion to be detected of the battery cell 100 is detected using the radiation unit 31 and the detector unit 32.

According to detection requirements, the first moving mechanism 22 may sequentially rotate one or more portions to be detected of the battery cell 100 into the beam region, and the detection device 3 sequentially detects the one or more portions to be detected.

After the battery cell 100 is gripped by the first gripping mechanism 21 and separated from the conveying surface of the conveying device 1, the position and orientation of the battery cell 100 may be adjusted by the first moving mechanism 22, enabling the detection of any portion to be detected of the battery cell 100, which facilitates the detection flexibility and helps to improve the detection efficiency.

In an optional embodiment, conveying the battery cell 100 to the gripping station includes: conveying a battery cell 100 to the first gripping station, and conveying another battery cell to the second gripping station; transferring the battery cell 100 from the gripping station to the detection station includes: transferring a battery cell 100 from the first gripping station to the detection station, and simultaneously transferring another battery cell 100 from the second gripping station to the detection station.

Specifically, the battery cell detection system includes a first transfer device 2 and a second transfer device 4, and the detection device 3 may simultaneously detect two battery cells 100.

Two gripping stations, including the first gripping station and the second gripping station, are provided in the conveying direction of the conveying device 1. Two adjacent battery cells 100 may move with the conveyor belt to the first gripping station and the second gripping station, respectively.

When the two adjacent battery cells 100 are respectively conveyed to the first gripping station and the second gripping station, the first transfer device 2 and the second transfer device 4 may simultaneously transfer the battery cell 100 at the first gripping station and the battery cell 100 at the second gripping station to the detection station to enable a simultaneous detection of the two battery cells 100, thereby improving the detection efficiency.

In an optional embodiment, the conveying device 1 includes a first conveying mechanism 11 and a second conveying mechanism 12. A predetermined gap is formed between a tail end of the first conveying mechanism 11 and a head end of the second conveying mechanism 12. The predetermined gap is configured to allow radiation generated by the detection device 3 to pass through. The first conveying mechanism 11 and the second conveying mechanism 12 are located on opposite sides of the detection device 3.

The first conveyor belt of the first conveying mechanism 11 rotates to convey a battery cell 100 to the first gripping station corresponding to the first conveying device 2. The first conveyor belt of the first conveyor mechanism 11 and the second conveyor belt of the second conveyor mechanism 12 synchronously rotate to convey another battery cell 100 from the first conveyor belt to the second conveyor belt. Further, the another battery cell 100 may further move with the second conveyor belt to the second gripping station corresponding to the second transfer device 4.

The tail end of the first conveying mechanism 11 is opposite to the head end of the second conveying mechanism 12, and a predetermined gap is formed between the tail end of the first conveying mechanism 11 and the head end of the second conveying mechanism 12. A conical contour surface of the radiation beam emitted by the radiation unit 31 is located in the predetermined gap. The radiation is directly received by the detector unit 32 after passing through the portion to be detected of the battery cell 100, thereby effectively avoiding the interference of the conveying device 1 to the imaging system.

The first conveying mechanism 11 and the second conveying mechanism 12 cooperate to convey the battery cell 100. In addition, the predetermined gap formed between the first conveying mechanism 11 and the second conveying mechanism 12 may effectively avoid an interference with the imaging system of the detection device 3, which helps improve the quality of the scan image and further improve the detection accuracy.

In an optional embodiment, rotating the portion to be detected of the battery cell 100 to the predetermined position to enable a detection of the portion to be detected of the battery cell 100 includes: sequentially rotating a first portion to be detected 101 and a second portion to be detected 102 of a battery cell 100 gripped by the first transfer device 2 to the predetermined position, and sequentially detecting the first portion to be detected 101 and the second portion to be detected 102; simultaneously, sequentially rotating a third portion to be detected 103 and a fourth portion to be detected 104 of another battery cell 100 gripped by the second transfer device 4 to the predetermined position, and sequentially detecting the third portion to be detected 103 and the fourth portion to be detected 104, where any portion to be detected of a battery cell 100 gripped by the first transfer device 2 and any portion to be detected of another battery cell 100 gripped by the second transfer device 4 are detected simultaneously.

Specifically, the conveying device 1 conveys the first battery cell to the first gripping station, and the first transfer device 2 moves to the first gripping station, where the first battery cell is gripped by the first gripping mechanism 21. The first linear motion mechanism 221 moves the first battery cell to the detection station by a horizontal linear motion. The first lifting mechanism 222 moves the first battery cell to the detection reference plane by a lifting motion. The first rotary mechanism 223 rotates the first portion to be detected 101 of the first battery cell into the beam region by a rotational motion, and the detection device 3 performs a detection on the first portion to be detected 101. After that, the first rotary mechanism 223 rotates the second portion to be detected 102 of the first battery cell into the beam region by a rotational motion, and the detection device 3 performs a detection on the second portion to be detected.

After the detection of the first portion to be detected 101 and the second portion to be detected 102 is completed, the first lifting mechanism 222 lower the first battery cell to a position near the conveying surface of the conveyor belt. The first gripping mechanism 21 places the first battery cell on the conveyor belt, and the first battery cell moves with the conveyor belt to the second gripping station.

The second transfer device 4 moves to the second gripping station, where the first battery cell is gripped by the second gripping mechanism 41. The first linear motion mechanism 221' moves the first battery cell to the detection station by a horizontal linear motion. The second lifting mechanism 421 moves the first battery cell to the detection reference plane by a lifting motion. The second rotary mechanism 422 rotates the third portion to be detected 103 of the first battery cell into the beam region by a rotational motion, and the detection device 3 performs a detection on the third portion to be detected 103. After that, the second rotary mechanism 422 rotates the fourth portion to be detected 104 of the first battery cell into the beam region by a rotational motion, and the detection device 3 performs a detection on the fourth portion to be detected 104.

It may be understood that when the first battery cell moves to the second gripping station, the second battery cell moves with the conveyor belt to the first gripping station. While the second gripping mechanism 41 grips the first battery cell at the second gripping station, the first gripping mechanism 21 grips the second battery cell at the first gripping station.

When the second moving mechanism 42 moves the first battery cell from the second gripping station to the detection station, the first moving mechanism 22 moves the second battery cell from the first gripping station to the detection station. The second rotary mechanism 422 rotates the third portion to be detected 103 of the first battery cell into the beam region by a rotational motion, and the first rotary mechanism 223 simultaneously rotates the first portion to be detected 101 of the second battery cell into the beam region by a rotational motion. The detection device 3 may then simultaneously detect the third portion to be detected 103 of the first battery cell and the first portion to be detected 101 of the second battery cell. Similarly, the detection device 3 may simultaneously detect the fourth portion to be detected 104 of the first battery cell and the second portion to be detected 102 of the second battery cell.

The first transfer device 2 sequentially moves the first portion to be detected 101 and the second portion to be detected 102 of the battery cell 100 into the beam region to complete the detection of the first portion to be detected 101 and the second portion to be detected 102. The second transfer device 4 sequentially moves the third portion to be detected 103 and the fourth portion to be detected 104 of the battery cell 100 into the beam region to complete the detection of the third portion to be detected 103 and the fourth portion to be detected 104.

While the first transfer device 2 moves a portion to be detected of a battery cell 100 into the beam region, the second transfer device 4 simultaneously moves a portion to be detected of another battery cell 100 into the beam region. The detection device 3 may simultaneously detect the two portions to be detected of the two battery cells 100, which helps to improve the detection efficiency.

In an optional embodiment, rotating the portion to be detected of the battery cell 100 to the predetermined position to enable a detection of the portion to be detected of the battery cell includes: sequentially rotating a first portion to be detected 101, a second portion to be detected 102, a third portion to be detected 103 and a fourth portion to be detected 104 of a battery cell 100 gripped by the first transfer device 2 to the predetermined position, and sequentially detecting the first portion to be detected 101, the second portion to be detected 102, the third portion to be detected 103 and the fourth portion to be detected 104; and simultaneously, sequentially rotating a fourth portion to be detected 104, a third portion to be detected 103, a second portion to be detected 102 and a first portion to be detected 101 of another battery cell gripped by the second transfer device 4 to the predetermined position, and sequentially detecting the fourth portion to be detected 104, the third portion to be detected 103, the second portion to be detected 102 and the first portion to be detected 101; where any portion to be detected of a battery cell 100 gripped by the first transfer device 2 and any portion to be detected of another battery cell 100 gripped by the second transfer device 4 are detected simultaneously.

Specifically, the conveying device 1 may convey the first battery cell to the first gripping station and convey the second battery cell to the second gripping station.

The first transfer device 2 moves to the first gripping station, and the second transfer device 4 simultaneously moves to the second gripping station. The first gripping mechanism 21 grips the first battery cell at the first gripping station, and the first moving mechanism 22 moves the first battery cell to the detection station. At the same time, the second gripping mechanism 41 grips the second battery cell at the second gripping station, and the second moving mechanism 42 moves the second battery cell to the detection station.

The first rotary mechanism 223 rotates the first portion to be detected 101 of the first battery cell into the beam region, and the second rotary mechanism 422 simultaneously rotates the fourth portion to be detected 104 of the second battery cell into the beam region. The detection device 3 may then simultaneously detect the first portion to be detected 101 of the first battery cell and the fourth portion to be detected 104 of the second battery cell.

After that, the first rotary mechanism 223 rotates the second portion to be detected 102 of the first battery cell into the beam region, and the second rotary mechanism 422 simultaneously rotates the third portion to be detected 103 of the second battery cell into the beam region. The detection device 3 may then simultaneously detect the second portion to be detected 102 of the first battery cell and the third portion to be detected 103 of the second battery cell.

Then, the first rotary mechanism 223 rotates the third portion to be detected 103 of the first battery cell into the beam region, and the second rotary mechanism 422 simultaneously rotates the second portion to be detected 102 of the second battery cell into the beam region. The detection device 3 may then simultaneously detect the third portion to be detected 103 of the first battery cell and the second portion to be detected 102 of the second battery cell.

Subsequently, the first rotary mechanism 223 rotates the fourth portion to be detected 104 of the first battery cell into the beam region, and the second rotary mechanism 422 simultaneously rotates the first portion to be detected 101 of the second battery cell into the beam region. The detection device 3 may then simultaneously detect the fourth portion to be detected 104 of the first battery cell and the first portion to be detected 101 of the second battery cell.

The first transfer device 2 sequentially moves the first portion to be detected 101, the second portion to be detected 102, the third portion to be detected 103 and the fourth portion to be detected 104 of the first battery cell into the beam region to complete the detection of the four portions to be detected. At the same time, the second transfer device 4 sequentially moves the fourth portion to be detected 104, the third portion to be detected 103, the second portion to be detected 102 and the first portion to be detected 101 of the second battery cell into the beam region to complete the detection of the four portions to be detected.

While the first transfer device 2 moves a portion to be detected of a battery cell 100 into the beam region, the second transfer device 4 simultaneously moves a portion to be detected of another battery cell 100 into the beam region. The detection device 3 may simultaneously detect the two portions to be detected of the two battery cells 100, which helps to improve the detection efficiency.

The battery cell detection system and the detection method thereof provided in embodiments of the present disclosure may achieve at least the following technical effects. The conveying device 1 is used to convey and buffer a battery cell to be detected, and the first transfer device is used to transfer the battery cell from the gripping station to the detection station. At the detection station, according to detection requirements, the first moving mechanism may move any portion to be detected of the battery cell to the predetermined position to detect one or more portions to be detected of the battery cell, which facilitates the detection flexibility and improves the detection efficiency.

The above descriptions are merely specific embodiments of the present disclosure, and the scope of protection of the present application is not limited thereto. Any changes or substitutions made within the spirit and principle of the present disclosure should fall within the scope of protection of the present disclosure. Therefore, the scope of protection of the present disclosure should be determined by the scope of protection of the claims.

## Claims

1. A battery cell detection system, comprising:
a conveying device (1) configured to convey a battery cell to a gripping station;
a first transfer device (2) disposed opposite to the conveying device (1) in a vertical direction, wherein the first transfer device (2) comprises a first gripping mechanism (21) and a first moving mechanism (22) connected to each other, the first gripping mechanism (21) is configured to grip the battery cell, and the first moving mechanism (22) is configured to transfer the battery cell from the gripping station to a detection station and configured to move a portion to be detected of the battery cell to a predetermined position; and
a detection device (3) disposed at the detection station, wherein the detection device (3) is configured to detect the portion to be detected of the battery cell.

2. The battery cell detection system according to claim 1, wherein the first moving mechanism (22) comprises:
a first linear motion mechanism (221) configured to be movable in a first direction to move the battery cell from the gripping station to the detection station;
a first lifting mechanism (222) configured to be movable in the vertical direction to move the battery cell to a detection reference plane of the detection device (3); and
a first rotary mechanism (223) connected to either the first linear motion mechanism (221) or the first lifting mechanism (222) and connected to the first gripping mechanism (21), wherein the first rotary mechanism (223) is configured to drive the battery cell to rotate so that the portion to be detected of the battery cell rotates to the predetermined position.

3. The battery cell detection system according to claim 2, wherein:
the first moving mechanism further comprises a second linear motion mechanism (224) connected to the first linear motion mechanism (221) and to the first lifting mechanism (222); and
the second linear motion mechanism (224) is configured to be movable in a second direction to drive the first lifting mechanism (222) and the first rotary mechanism (223) to move in the second direction, so that a rotation axis of the first rotary mechanism (223) is located within a central plane of the detection device (3), wherein the second direction intersects with the first direction.

4. The battery cell detection system according to claim 2, wherein the first rotary mechanism (223) is configured to drive the first gripping mechanism (21) to rotate by a target angle, so that any portion to be detected of the battery cell rotates to the predetermined position.

5. The battery cell detection system according to claim 1, further comprising:
a tray (200) configured to carry the battery cell, wherein the conveying device (1) is configured to covey the tray (200) carrying the battery cell to the gripping station.

6. The battery cell detection system according to any one of claims 1 to 5, further comprising a second transfer device (4), wherein:
the first transfer device (2) and the second transfer device (4) are located on opposite sides of the detection device (3) and have the same structure, and the second transfer device (4) comprises a second gripping mechanism (41) and a second moving mechanism (42) connected to each other;
the first transfer device (2) is configured to transfer a battery cell on one side of the detection device (3) to the detection station, and the second transfer device (4) is configured to transfer another battery cell on the other side of the detection device (3) to the detection station; and
the detection device (3) is configured to simultaneously detect the battery cell gripped by the first transfer device (2) and the battery cell gripped by the second transfer device (4).

7. The battery cell detection system according to claim 6, wherein:
the conveying device (1) comprises a first conveying mechanism (11) and a second conveying mechanism (12), and a predetermined gap is formed between a tail end of the first conveying mechanism (11) and a head end of the second conveying mechanism (12) to allow radiation generated by the detection device (3) to pass through; and
the first conveying mechanism (11) is configured to convey a battery cell to a first gripping station corresponding to the first conveying device (1), and the first conveying mechanism (11) and the second conveying mechanism (12) are configured to cooperatively convey another battery cell to a second gripping station corresponding to the second conveying device (1).

8. The battery cell detection system according to claim 7, wherein the conveying device (1) further comprises:
a first stop mechanism (13) disposed on the first conveying mechanism (11) to stop a battery cell at the first gripping station; and/or
a second stop mechanism (14) disposed on the second conveying mechanism (12) to stop another battery cell at the second gripping station.

9. A detection method for the battery cell detection system according to any one of claims 1 to 8, comprising:
conveying a battery cell to a gripping station;
transferring the battery cell from the gripping station to a detection station; and
rotating a portion to be detected of the battery cell to a predetermined position to enable a detection of the portion to be detected of the battery cell.

10. The detection method according to claim 9, wherein the conveying a battery cell to a gripping station comprises: conveying a battery cell to a first gripping station and conveying another battery cell to a second gripping station; and
wherein the transferring the battery cell from the gripping station to a detection station comprises: transferring a battery cell from the first gripping station to the detection station and simultaneously transferring another battery cell from the second gripping station to the detection station.

11. The detection method according to claim 10, wherein the rotating a portion to be detected of the battery cell to a predetermined position to enable a detection of the portion to be detected of the battery cell comprises:
sequentially rotating a first portion to be detected (101) and a second portion to be detected (102) of a battery cell gripped by the first transfer device (2) to the predetermined position, and sequentially detecting the first portion to be detected (101) and the second portion to be detected (102); and
simultaneously, sequentially rotating a third portion to be detected (103) and a fourth portion to be detected (104) of another battery cell gripped by the second transfer device (4) to the predetermined position, and sequentially detecting the third portion to be detected (103) and the fourth portion to be detected (104), wherein any portion to be detected of the battery cell gripped by the first transfer device (2) and any portion to be detected of the battery cell gripped by the second transfer device (4) are detected simultaneously.

12. The detection method according to claim 10, wherein the rotating a portion to be detected of the battery cell to a predetermined position to enable a detection of the portion to be detected of the battery cell comprises:
sequentially rotating a first portion to be detected (101), a second portion to be detected (102), a third portion to be detected (103) and a fourth portion to be detected (104) of a battery cell gripped by the first transfer device (2) to the predetermined position, and sequentially detecting the first portion to be detected (101), the second portion to be detected (102), the third portion to be detected (103) and the fourth portion to be detected (104); and
simultaneously, sequentially rotating a fourth portion to be detected (104), a third portion to be detected (103), a second portion to be detected (102) and a first portion to be detected (101) of another battery cell gripped by the second transfer device (4) to the predetermined position, and sequentially detecting the fourth portion to be detected (104), the third portion to be detected (103), the second portion to be detected (102) and the first portion to be detected (101),
wherein any portion to be detected of the battery cell gripped by the first transfer device (2) and any portion to be detected of the battery cell gripped by the second transfer device (4) are detected simultaneously.

13. The detection method according to claim 10, wherein the conveying a battery cell to a first gripping station and conveying another battery cell to a second gripping station comprises:
conveying a battery cell to the first gripping station corresponding to a first transfer device (2) by a first conveying mechanism (11); and
conveying another battery cell to the second gripping station corresponding to a second transfer device (4) by the first conveying mechanism (11) and a second conveying mechanism (12) cooperatively,
wherein a predetermined gap is formed between a tail end of the first conveying mechanism (11) and a head end of the second conveying mechanism (12) to allow radiation generated by a detection device (3) to pass through.
